# EUROPEAN PATENT APPLICATION

(11) **EP 2 876 196 A1**
(43) Date of publication of application: **27.05.2015**
(21) Application number: 13193914.2
(22) Date of filing: 21.11.2013
(51) Int. Cl.: D06F 39/00, D06F 58/28

(54) **Household appliance provided with a control panel**

(71) Applicant: Electrolux Appliances Aktiebolag, 105 45 Stockholm (SE)
(72) Inventor: De Pellegrin, Andrea, 33080 Porcia (PN) (IT)
(74) Representative: Frare, Paolo

(57) **Abstract**

The present invention relates to a household appliance (1), preferably a laundry household appliance like a laundry washing machine or drier or washer-drier, provided with a control panel (2) comprising: a user interface (3) comprising one or more capacitive touch input regions (4); an electronic board (5) comprising one or more electrically conductive tracks (6); one or more electrodes (7) having two ends (7a, 7b), one end (7a) being electrically connected to one of said one or more electrically conductive tracks (6) and the other end (7b) being positioned at or in proximity of one of said one or more capacitive touch input regions (4). The household appliance (1) comprises a capacitive module (8) comprising an insulating support element (9), made at least partially of electrically insulating material, in which said one or more electrodes (7) are fixed and partially embedded. The invention relates also to a method for manufacturing a capacitive module (8) for a household appliance (1) control panel (2), comprising the following steps: a) providing a mold (50) adapted to house one or more electrodes (7), said mold (50) being arranged in such a way that by injecting a melted insulating plastic material in said mold (50) after housing said one or more electrodes (7) therein, said one or more electrodes (7) are partially embedded in a plastic body (10, 94) formed by said plastic material and protrude with two ends (7a, 7b) from said plastic body (10, 94); b) housing one or more electrodes (7) in said mold (50); c) injecting a melted insulating plastic material in said mold (50), so as to obtain a capacitive module (8) comprising said one or more electrodes (7) and a plastic body (10, 94) partially embedding said one or more electrodes (7); d) extracting said capacitive module (8) from said mold (50).

## Description

The invention refers to a household appliance, preferably a laundry appliance like a laundry washing machine, a laundry drier, or a washer/direr, provided with a control panel. The invention further refers to a method for manufacturing a capacitive module for a household appliance control panel system.

Known household appliances such as laundry machines, i.e. washing machines, driers, and combined washer/driers, are usually provided with a user interface comprising a dashboard or control panel with input devices, knobs, buttons, etc., allowing the user to select or set washing and/or drying programs. The dashboards are typically provided also with output devices such as displays, LEDs, etc. for giving a feedback to the user related to the settings/status of the machine.

Some of these dashboards are provided with capacitive touch sensitive input devices that detect the contact of the user by means of capacitive change. Known touchsensitive dashboards for instance comprise an electronic board which is connected to the mains and to the electric components of machine fixed inside a plastic box which is fixed to or obtained as a single body with the control panel.

The electronic board is usually provided with a plurality of electric tracks constituting the electrodes of the capacitive touch sensors. A capacitive module shaped as a metallic spring is fixed to each track at one end, and at the other end it is provided with an electrode which is positioned behind a suitable printing or other indicating element in the control panel which indicates the position of the electrode. When a user positions his/her finger on the printing or indicator element, he/she changes the electric capacity detected by the electrode and therefore by the capacitive sensor.

WO 2011/119696 A2 discloses an appliance control panel system comprising a control panel interface with touch keys and a circuit board assembly with receiver pads. The electrical connection between the touch keys of the control panel and the corresponding receiver pads is achieved via conductive extenders which are situated between the control panel interface and the circuit board assembly. The extenders can be made of conductive material such as foam pad or can be designed as springs.

A household appliance with a control panel, a circuit board and a touch button is disclosed in WO 2013/064572 A1. The signal resulting from a capacitive difference when the user touches the button is transmitted to a sensor by a respective spring of which one end is fixed to the circuit board. The springs are surrounded by a housing almost without a gap.

US 7,741,858 B2 describes a capacitive switch of an electric/electronic device with a control panel with contacts disposed at the front of the panel and capacitive sensors disposed at the rear of the control panel. A plurality of void removal elements is disposed between the capacitive sensors and the contacts and electrically connected to them.

A capacitive touch switch with a touch panel and a printed circuit board is disclosed in EP 1 786 107 B1. A capacitive sensor element between the underside of the touch panel and the printed circuit board is in electrically conductive conduct with the printed circuit board and has a compression spring of an electrically conductive material.

Disadvantageous of these described technical solutions is that the springs are difficult to assemble to the electronic board and to be positioned inside the box since they tend to get stuck one another. This leads to technical issues with respect to assembly. Additionally, the manufacturing of several distinct components such as separate capacitive modules or buttons is rather cost intensive.

The aim of the invention is therefore to provide a household appliance with a very robust and reliable control panel which is easy to assemble. Another aim of the invention is to provide a method for manufacturing such a keyboard.

### Disclosure of the invention

The present invention therefore relates, in a first aspect thereof, to a household appliance provided with a control panel comprising: a user interface comprising one or more capacitive touch input regions; an electronic board comprising one or more electrically conductive tracks; one or more electrodes having two ends, one end being electrically connected to one of said one or more electrically conductive tracks and the other end being positioned at or in proximity of one of said one or more capacitive touch input regions. The household appliance comprises a capacitive module comprising an insulating support element, made at least partially of electrically insulating material, in which said one or more electrodes are fixed and partially embedded.

Preferred embodiments of the invention are described in relation to the dependent claims and the description of the enclosed drawings.

The invention is based on the consideration that the control panel of the household appliance is an essential component of which robust and reliable functionality are demanded. Since household appliances are usually and often transported to the customer the corresponding components should provide mechanical robustness and should allow being subjected to mechanical stress without losing their functionality. Especially important for operating a household appliance is the functionality that user commands are accurately transferred to the control logic which, dependent on the user choice, controls the appliance. With known solutions, already during the assembly of the appliance problems may arise with false positioning of the electrodes. During transport, components may move and wedge which in the long term may lead to reduced functionality or failure.

The applicant has found that these problems can be avoided if the one or more electrodes are firmly embedded in a body made of at least partially non-conductive (preferably plastic) material surrounding them. This leads to a well-defined spatial orientation and reciprocal positioning of the electrodes when the capacitive module is installed. During transport, no friction or contact between lose component is thus allowed. Thus, in the long term, reliable functionality of the control panel can be provided.

The term "embedded" hereby means that the respective electrode is partially surrounded or enclosed by the material in such a way that it cannot be removed without breaking or tearing apart the non-conductive or plastic material.

In a preferred embodiment at least two electrodes are fixed and partially embedded in the at least partially electrically insulating material in such a way to be reciprocally electrically insulated one another. Preferably, the number of touch regions and the number of conductive tracks respectively correspond to the number of electrodes, whereby each electrode advantageously connects exactly one touch region with one conductive track. The connection hereby involves the functionality that a capacitive change of the touch input region, which preferably is built as a capacitive sensor, is signaled and/or transported to the electronic board, allowing it to react. The electrodes that connect directly neighboring touch regions are advantageously positioned next to each other in order to avoid unnecessary distances and/or contacts which could lead to malfunctions.

Preferably, the insulating support element comprises a single plastic body obtained by injection molding and over-injected on all said one or more electrodes in such a way to partially embed all of them and to allow said two ends of each electrode to protrude externally from said plastic body. Such a configuration is especially robust and easy to handle in the assembling process of the control panel.

The term "over-injection" denotes the process of injection molding, where material is injected into a mold in which the at least one electrode is placed in such a way that the material moves around the electrode and encloses it partially and partially covers it. The respective electrode is thus partly both embedded and fixed in the material.

In an alternative embodiment, the insulating support element comprises a plurality of plastic bodies obtained by injection molding and each one over-injected on at least one of said one or more electrodes in such a way to partially embed it and to allow said two ends of said at least one of said one or more electrodes to protrude externally from said plastic body.

In an advantageous embodiment, the plastic bodies, each comprising at least one of said one or more electrodes, are advantageously connected one another after their injection molding so as to form said capacitive module. For the connection between two plastic bodies, any kind of suitable mechanical connection can be used as long as it allows a well-defined and firm relative positioning between two adjacent plastic bodies.

In an advantageous embodiment, in order to provide a robust connection between the plastic bodies, the plurality of plastic bodies is preferably fixed to a rack supporting them. Additionally, the plastic bodies can be advantageously connected one another to provide extra stability.

The control panel of the household appliance advantageously comprises a front wall having an external surface facing the external of the appliance and comprising one or more capacitive touch input regions, the control panel comprising an internal surface provided in or in proximity of the front wall and facing the electronic board, the capacitive module being positioned between electronic board and internal or rear surface.

Preferably, the control panel comprises a box housing the electronic board and having an external wall facing the front wall of the control panel, the external wall comprising the internal surface facing the electronic board and the capacitive module being positioned between the electronic board and internal surface. A box can provide extra stability and provide protection of the electronic components with respect to environmental influences.

Advantageously, the end of an electrode positioned at or in proximity of one of the one or more capacitive touch input regions abuts against the internal surface of the control panel and is made of an elastic conductive material so as to elastically adapt its shape/position to the actual distance between the respective conductive track and the internal surface of the control panel. Such a configuration allows establishing reliable electrical contact for an interval of distances between the respective conductive track and the internal surface of the control panel and thus can compensate for tolerances during the manufacturing and/or assembling processes.

Preferably the household appliance is a laundry washing machine or a laundry drier or a washer-drier. It has to be understood that the invention is particularly useful for laundry washing machines and washer-driers, since in use they are exposed to high vibrations (in particular during the spinning phases), and therefore the robustness of the capacitive module is essential.

The present invention relates, in a second aspect thereof, to a method for manufacturing a capacitive module for a household appliance control panel, comprising the steps
a) providing a mold adapted to house one or more electrodes, said mold being arranged in such a way that by injecting a melted insulating plastic material in said mold after housing said one or more electrodes therein, the one or more electrodes are partially embedded in a plastic body formed by the plastic material and protrude with two ends from the plastic body;
b) housing one or more electrodes in the mold;
c) injecting a melted insulating plastic material in the mold so as to obtain a capacitive module comprising one or more electrodes and a plastic body partially embedding said one or more electrodes;
d) extracting the capacitive module from the mold.

In a preferred variant or embodiment, the mold is adapted to house a plurality of electrodes, one spaced apart from the others/mutually spaced apart from each other, the above described phase or step b) comprising housing a plurality of electrodes, one spaced apart from the others or mutually spaced apart from each other, in the mold.

In another preferred variant, the mold is adapted to house a single metallic body comprising a plurality of electrodes, phase or step b) comprising housing the single metallic body in the mold, wherein this method comprises, after phase or step c), the following step:
c1) reciprocally separating the electrodes of the metallic body so as to electrically insulate them one another, while keeping them partially embedded in the plastic body.

A single metallic body is easy to produce by die cutting of a metal plate and provides well-defined distances between the electrodes during the process of injection molding.

Preferably, step c1) is performed before performing phase or step d); i.e. step c1) is performed while the capacitive module is still in the mold, for example by using a cutting element provided in the mold and adapted to reciprocally separate the electrodes while they are housed in the mold.

In a preferred variant, a capacitive module with a plurality of plastic bodies is produced, each one embedding one or more electrodes, further comprising the step of connecting the plurality of plastic bodies one to the other via respective plastic bodies.

The advantages of the invention are especially as follows. The capacitive module provides an integration of components and consequently leads to a reduction of parts. This allows cost saving since the production of a single module is less expensive than the production of several loose components. When several plastic bodies are produced which are then connected to each other or to a common support structure, variants with different number of electrodes can easily be assembled.

The capacitive module allows a comfortable handling in all production phases and an easy and reliable assembling operation. Moreover, damages during transport can be reduced and safety can be increased, which enhance the reliability and life period of the control panel and the household appliance.

### Brief description of the Drawings

Further characteristics and advantages of the present invention will be highlighted in greater detail in the following detailed description of some of its preferred embodiments, provided with reference to the enclosed drawings. In said drawings:
- FIG. 1: shows a household appliance with a control panel;
- FIG. 2: shows the control panel shown in FIG. 1 comprising a user interface, an electronic board, a box and a capacitive module in a first preferred embodiment with six electrodes in an exploded view from a first viewing angle;
- FIG. 3: shows the control panel of FIGs. 1 and 2 in an exploded view from a second viewing angle;
- FIG. 4: shows a capacitive module of the control panel shown in FIGs. 1 through 3 with six embedded electrodes;
- FIG. 5: shows the control panel of FIGs. 1 through 3 in a front view;
- FIG. 6: shows the control panel of FIG. 5 in a side view;
- FIG. 7: shows the control panel of FIG. 5 in a back view;
- FIG. 8: shows a single metallic body used in a preferred variant of a method for manufacturing a control panel;
- FIG. 9: shows a mold used in the preferred method variant with the single metallic body of FIG. 8 placed in a cavity;
- FIG. 10: shows the mold according to FIG. 9 with an upper component;
- FIG. 11: shows a detailed view of a part of the cavity with inflowing plastic material;
- FIG. 12: shows a capacitive module in a second preferred embodiment manufactured by the method illustrated in FIGs. 8 through 11 with a support element and four embedded electrodes;
- FIG. 13: shows the capacitive module of FIG. 12 in a perspective view;
- FIG. 14: shows the capacitive module of FIGs. 12 and 13 whereby the support element is drawn as a transparent lattice model;
- FIG. 15a: shows the capacitive module of FIGs. 12 to 14 form a top view before the cutting of the struts between neighboring electrodes;
- FIG. 15b: shows the capacitive module of FIG 15a in a schematic view in which the insulating support member is represented as transparent, so as to allow seeing the embedded part of the electrodes;
- FIG. 15c: shows the capacitive module of FIGs. 12 to 14 form a top view after the cutting of the struts between neighboring electrodes;
- FIG. 15d: shows the capacitive module of FIG 15c in a schematic view in which the insulating support member is represented as transparent, so as to allow seeing the embedded part of the electrodes;
- FIG. 16: shows a third preferred embodiment of a capacitive module in a perspective view;
- FIG. 17: shows the capacitive module of FIG. 16 from a different perspective;
- FIG. 18: shows a capacitive module with a plurality of plastic bodies in a fourth preferred embodiment in a perspective view;
- FIG. 19: shows a plastic body of the capacitive module of FIG. 18;
- FIG. 20: shows a capacitive module with a plurality of plastic bodies in a fifth preferred embodiment attached to a rack in a perspective view;
- FIG. 21: shows a plastic body of the capacitive module of FIG. 20;
- FIG. 22: shows the capacitive module of FIG. 20 in a different view;
- FIG. 23: shows the capacitive module of FIG. 20 in an exploded view.

### Detailed Description of the Invention

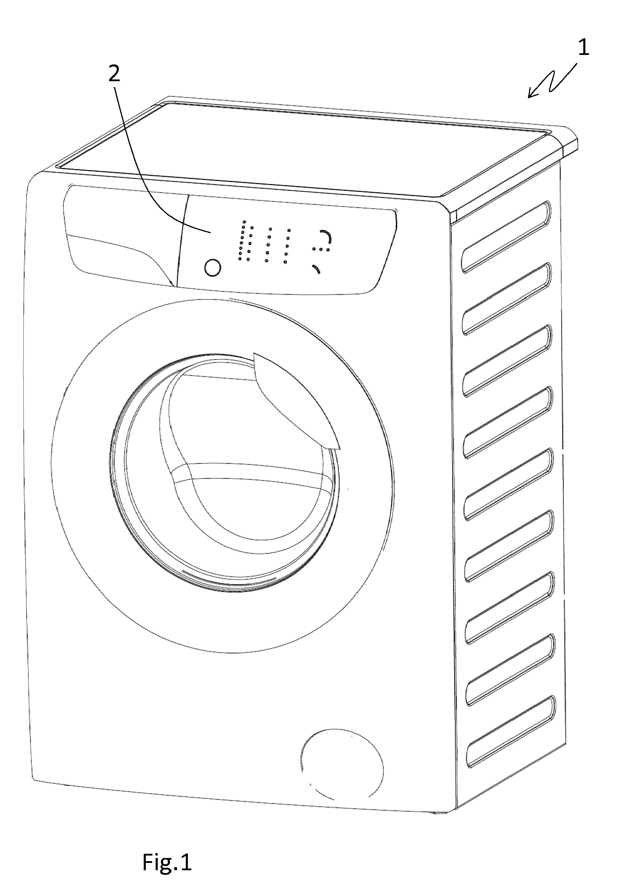

With reference to FIG. 1, a household appliance 1 is shown which is built as a front-loading laundry washing machine. Anyway the invention can be applied as well to top-loading washing machines, to laundry washer/driers and to tumble driers. Washing machine 1 advantageously comprises a control panel 2 through which the user can interact with the washing machine by, for instance, selecting a certain laundry program.

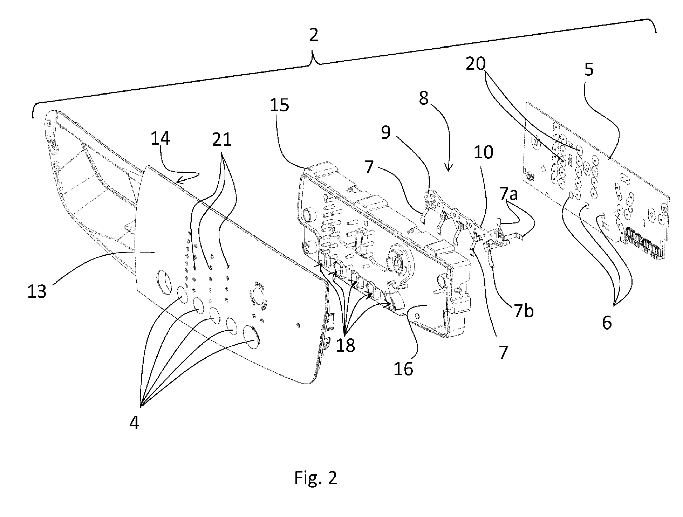

The control panel 2 shown in FIG. 1 is displayed in FIG. 2 in an exploded view. The control panel 2 comprises a user interface 3 for interaction with a user. The user interface 3 comprises several capacitive touch input regions 4, which preferably act and/or are built as capacitive sensors, and an electronic board 5 with several conductive tracks 6. Capacitive changes occurring when the user touches a touch input region 4 are transmitted to a corresponding conductive track 6 by an electrode 7. The respective electrode 7 comprises an end 7a which is electrically connected to a conductive track 6 and an end 7b which is positioned at or in proximity to a capacitive touch region 4. The proximity to or distance between the respective end 7b and the corresponding touch region is chosen to fulfill the requirement that the capacitive change of a user touching a touch region 4 can reliably be transferred to the electronic board 5 by the respective electrode 7.

Advantageously, the configuration of touch regions 4, electrodes 7, and electronic board 5 is chosen in such a way that each touch region 4 is electrically, i.e. capacitively, connected to exactly one conductive track 6 by exactly one electrode 7.

The household appliance comprises a control panel 2 which is designed to deliver long functional reliability and strong robustness during transportation or other mechanical stress or strain, for example during the spinning phase(s) of washing program in a washing machine. The control panel 2 therefore comprises a capacitive module 8 which comprises an insulating support element 9 which is at least partially made of electrically insulating material. The electrodes 7 are partially embedded in this material and fixed, meaning each electrode 7 is not allowed to move as a whole with respect to the support element 9. The electrodes 7 are in their embedded state electrically insulated from each other. This insulation is achieved by the choice of the material of the insulating support element 9 in such a way that insulating material is used at least in parts of the support element 9 which are necessary for the insulation of the electrodes 7. The support element 9 can be completely made of electrically insulting material. Alternatively, in one advantageous embodiment, insulting material can be used only in the regions of the support element 9 where electrodes 7 are embedded, while the peripheral parts of the support element 9 can be made of material which is not required to be electrically insulating.

The support element 9 in the advantageous embodiment illustrated in attached Figures 2-7, comprises a single plastic body 10 made of electrically insulating material, which is obtained or created by injection molding and over-injecting on all electrodes 7, which leads to a plastic body 10 which partially embeds all electrodes 7 but leaves their ends 7a, 7b freely protruding from the plastic body 10.

In this advantageous embodiment, capacitive module 8 is obtained by positioning all electrodes 7 in a suitable mold, all spaced apart from the others, then injecting a melted insulating plastic material in said mold, so as to partially embed these electrodes 7 (only the ends 7a and 7b of the electrodes being not embedded by the plastic material), and then, after solidification of the plastic material, extracting the so obtained capacitive module 8 from the mold.

The two main functions of the plastic body 10 are advantageously to fix or fixate the electrodes 7 and to electrically insulate them one another. The over-injection of the electrodes 7 leads to an especially stable and robust arrangement of the electrodes 7 and allows in the assembled state of the control panel 2 a reliable functioning, namely to capacitively couple a touch region 4 with the corresponding conductive track 6.

The control panel 2 comprises a front wall 12 with an external surface 13 comprising the touch regions 4 which in a state in which the control panel 2 is positioned at or in the household appliance 1 is the surface which faces the external surrounding and provides the interface to the user. On its opposite side, the control panel 2 comprises a rear or internal surface 14 which in an assembled state faces the electronic board 5. Both surfaces 13, 14 are advantageously surfaces of the user interface 3.

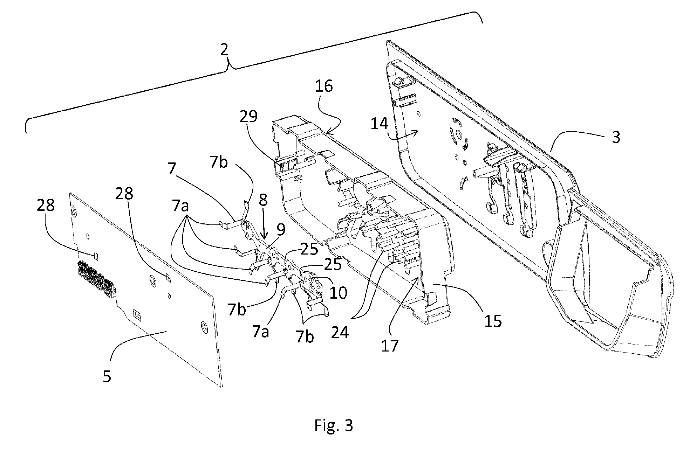

The control panel according to FIGs. 2 and 3 further comprises a box 15 which in the assembled state houses or receives the capacitive module 8 and the electronic board 5. Box 15 comprises an external wall 16 which faces the internal surface 14 of the user interface 3 and an internal wall 17 facing the electronic board 5. In an assembled state, the capacitive module 8 is positioned between the internal wall 17 and the electronic board 5. Box 15 can advantageously comprise one or more ducts 18 or openings which allow the capacitive connection between ends 7b and touch regions 4. Box 15 may further advantageously comprise light conductors 19 for transmitting light which is emitted from light emitting elements 20 to corresponding display elements 21 at the front wall 12 of the control panel 2.

The attachment of the capacitive module 8 to the box 15 can be achieved in different ways. One possibility is a multitude of pegs 24 protruding from the internal wall 17 of box 15 which are lead through holes 21 in the plastic body 10 during assembling of the control panel 2. Also, connections with clips or screws are possible.

Box 15 is an optional component which in other advantageous embodiments can be left out. The capacitive module 8 can then directly be attached to the user interface 3 on its interior or internal surface 14 and/or be attached to the electronic board 5.

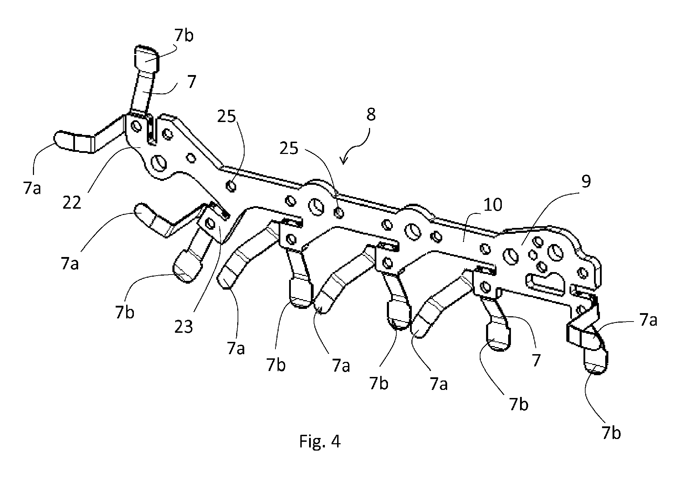

The capacitive module 8 illustrated in FIG. 4 comprises several holes 25 through one or more of which pegs 24 protruding from the internal wall 17 of box 15 are advantageously lead. Plastic body 10 illustrated in FIG. 4 is advantageously shaped as rack 22 with protruding fixing pieces 23 which, by over-injection, partially embed the respective electrode 7.

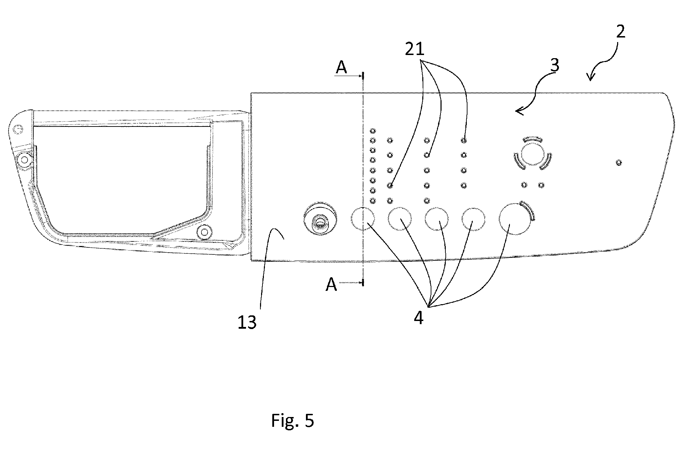

FIG. 5 displays a front view of the control panel 2 with the user interface 3 and its external surface 13. On its surface 13, touch regions 4 and display elements 21 are arranged which allow the user to interact with the household appliance 1 and, for instance, to select a desired washing program. The feedback to the user is advantageously provided via the display elements 21. Alternatively, an LCD display or any other kind of visual indication component can be used.

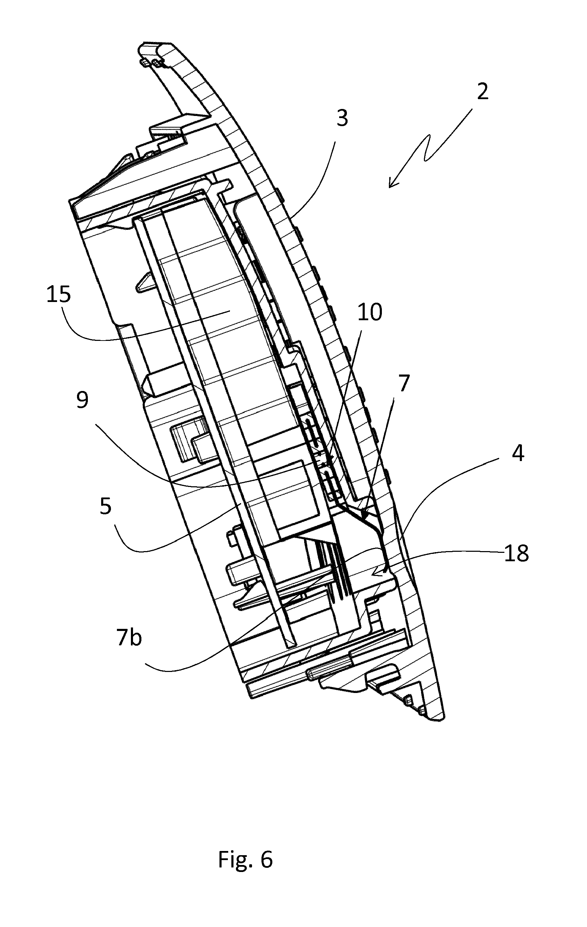

FIG. 6 shows a section through the line A-A of FIG. 5 of the control panel 2 in an assembled state.

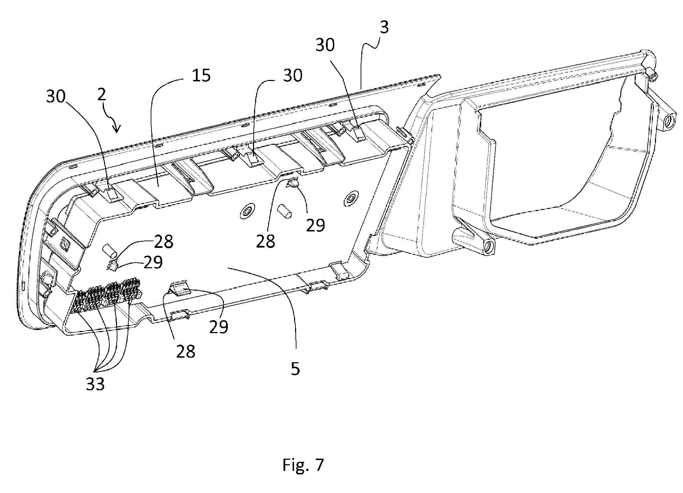

FIG. 7 shows a back view of the control panel 2 in an assembled state. Box 15 has been attached to user interface 3 and capacitive module 8 has been inserted. The electronic board 5 has been attached to box 15. The connection between box 15 and electronic board 5 is preferably performed by cuts 28 in the electronic board through which snap arms 29 or engagement hooks which are connected to box 15 or are part of box 15 are put through in which way a definite and firm positioning between box 15 and electronic board 5 is achieved. The control panel 2 may advantageously comprise snap arms 30 which engage with projections or cuts in the housing of the household appliance 1 for a detachable connection with the household appliance 1.

The electronic board 5 comprises several electrical connectors 33 for connecting electrical components of the household appliance.

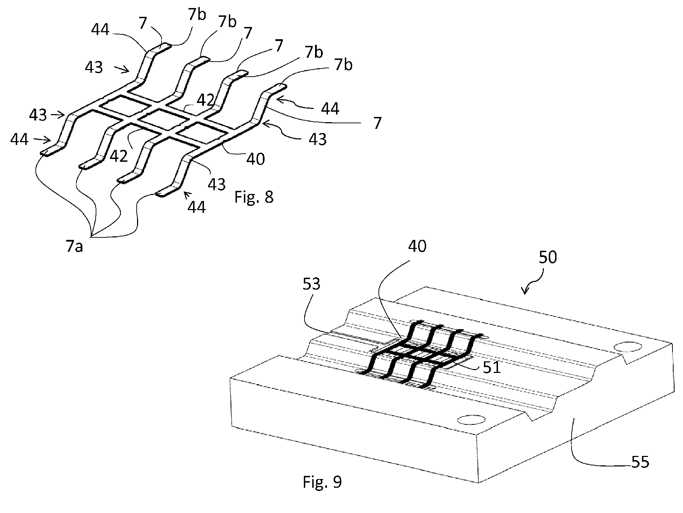

A preferred variant of a method for manufacturing a capacitive module 8 is displayed in context of the following FIGs. 8-15d. In order to obtain a capacitive module 8 comprising a support element 9 with a plastic body 10 with partially embedded electrodes 7, a single metallic body 40 as displayed in FIG. 8 is used.

The use of a single metallic body 40 simplifies the manufacturing process and the design of the cavity of the mold 50 which is employed to obtain the capacitive module 8. The single metallic body 40 is designed as a plurality of electrodes 7 which are connected by lateral struts 42 as to form a grid-like structure. The single metallic body 40 is manufactured as a one-piece component, for example by punching out from a metal plate (made of an electrical conductive metal) and bending of the conducting elements 41 in a first region 43 and a second region 44 at both of their ends, respectively.

As illustrated in FIG. 9, the single metallic body 40 is placed in a mold 50 (of which the lower component, an injection mold 55 is displayed), whereby the part of the single metallic body 40 which is later to be embedded is placed in a cavity 51 of mold 50. Cavity 51 is connected to a duct 53 or runner which forms a channel for directing melted insulating plastic material into cavity 51. Mold 50 is therefore adapted to house the single metallic body 40.

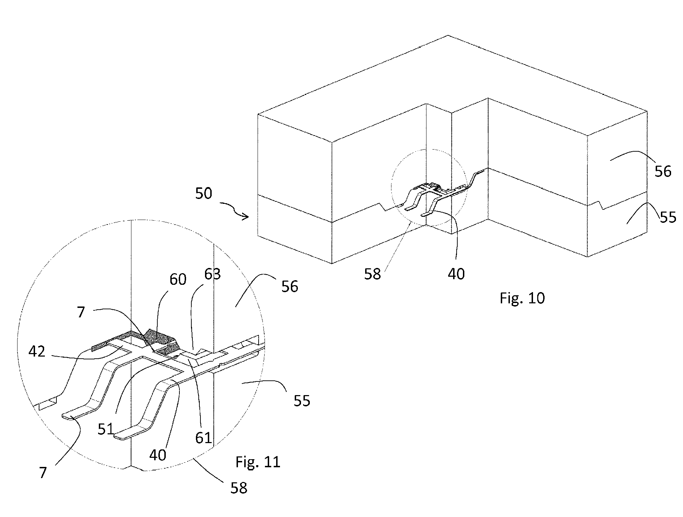

With reference to FIG. 10, which shows a section through the mold 50 and cavity 51, mold 50 comprises an injection mold 55 or A-plate and an ejector mold 56 or B-plate. During the injection molding process, ejector mold 56 is placed on injection mold 55 and closes cavity 51 such that injected material through the runner stays in the cavity and flows around metallic body 40.

With reference now to FIG. 11, in a circle 58 a magnified view of mold 50 is shown. Melted plastic material 60 is shown as it is flowing into cavity 51, flowing and partially enclosing electrode 7. On opposite sides in cavity 51, lower projections 61 and upper projections 63 are formed which narrow the flow passage for plastic material 60, leading to the thinner parts of the resulting plastic body 10 between electrodes 7. The plastic body 10 thus is thicker around electrodes 7 than in between them, by which material, weight and eventually costs can be reduced.

After the phase of injecting the plastic material 60 into the cavity 51 and after plastic material 60 has partially embedded the single metallic body 40, the electrodes 7 are reciprocally separated from each other in order to electrically insulate them from each other. This insulation is performed for example by cutting the struts 42 between neighboring electrodes 7 such that no flow of electric current between two respective electrodes 7 becomes possible.

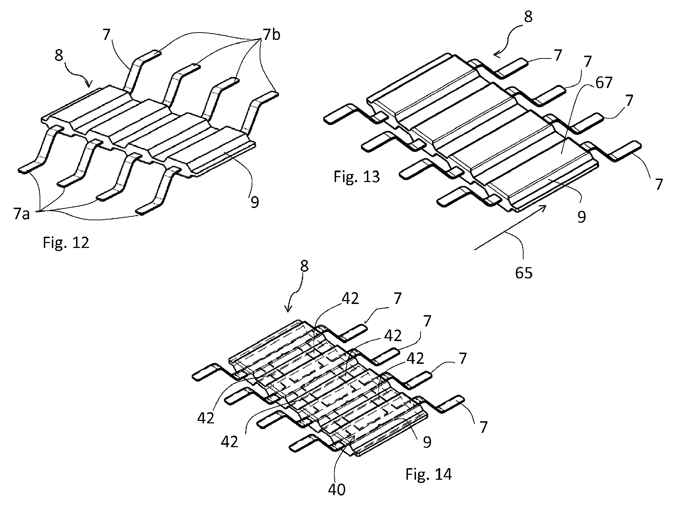

FIGs 12 to 15b show, in various views, the capacitive module 8 after the solidification of the plastic material composing the plastic body 10, but before the reciprocal electrical insulation of the electrodes 7 by cutting the struts 42 between neighboring electrodes 7.

The electrical insulation is established by a cutting device, not illustrated, which is preferably integrated into the mold 50. Preferably, the cutting device comprises a retractable cutter which can moved against an elastic element, especially a spring, to a retracting position during the inflow of melted plastic material. The cutter is moveable to a number of discrete positions between the housed electrodes 7 in the mold 50 and is operated to cut the struts 42 between adjacent electrodes 7 for respective electrical insulation.

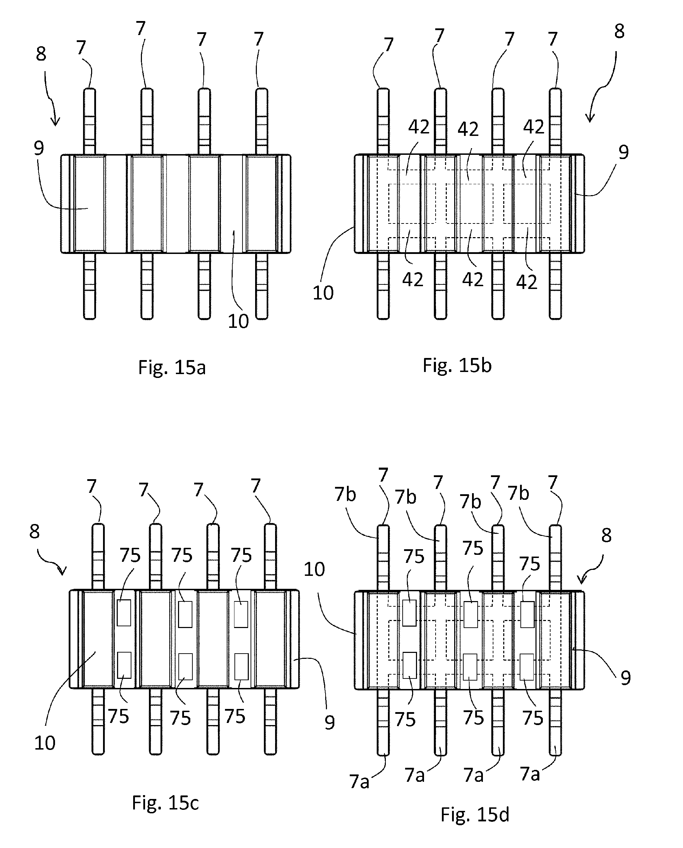

FIGs 15c and 15d show the capacitive module 8 after the reciprocal electrical insulation of the electrodes 7 by cutting the struts 42 between neighboring electrodes 7; holes 75, preferably pass-through holes, are obtained in the plastic body 10 in correspondence of the cuts of the struts 42 by the cutting device.

After plastic material has sufficiently hardened, and after cutting of the struts 42, plastic body 10 built from plastic material 60 is extracted from mold 50, especially from the ejector mold 56.

In FIG. 12, a capacitive module 8 resulting from the method described above, but before the cutting the struts 42 is displayed, and in FIG. 13, capacitive module 8 of FIG. 12 is displayed from a different viewing direction. The part of plastic body 10 which in a direction 65 partially embeds each respective electrode 7 is designed preferably with a truncated pyramid 67.

The capacitive module 8 of FIG. 13 is again displayed in FIG. 14 with the same viewing direction. For viewing purposes, plastic material 60 is represented as transparent, so that the part of the metallic body 40 which is embedded in the plastic material can be seen.

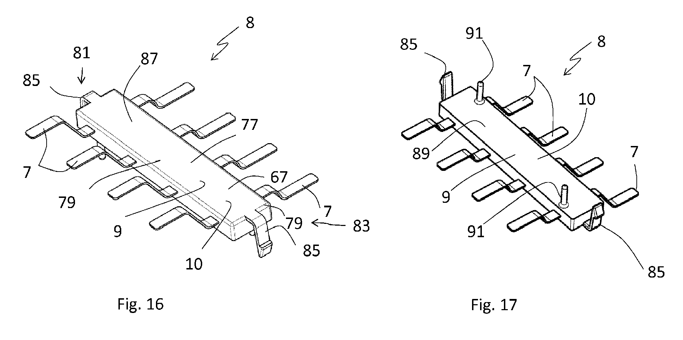

A capacitive module 8 in another preferred embodiment is displayed in FIG. 16. Plastic body 10 which builds the support element 9 is manufactured by a method as described above, whereby the cavity 51 is adapted to yield a shape of plastic body 10 as shown. Plastic body 10 is essentially designed as a cuboid. More generally, a parallelepiped can be used as the form of the plastic body 10. On a top side 77, the plastic body is designed with a truncated pyramid 67 with rounded edges 79 for easier handling. On each side 81, 83 of plastic body 10, a snap arm 85 protrudes from main body 87 of plastic body 10. In an assembled state of the control panel 2, the snap arms 85 engage with cuts, slits or openings in the box 15 or the user interface 3 in order to bring the capacitive module 8 in a fixed position with respect to the other components of the control panel 2.

With reference now to FIG. 17, from a bottom side 89 of capacitive module 8 according to FIG. 16, two pins or pegs 91 protrude vertically which engage in holes on box 15 or user interface 3.

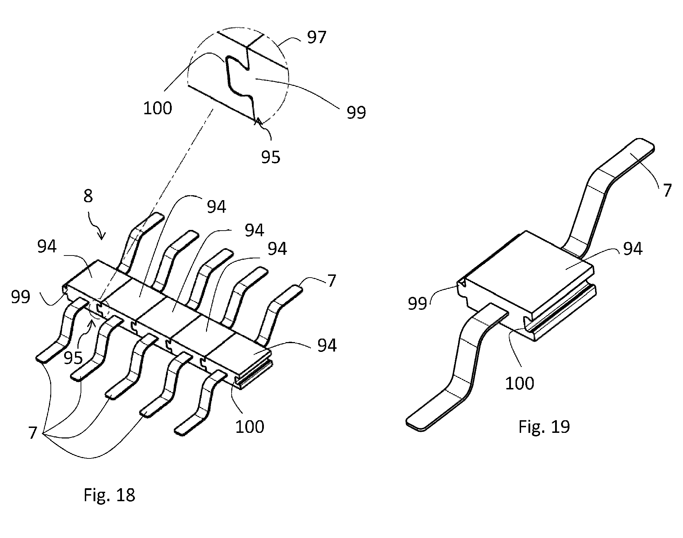

A capacitive module 8 in still another preferred embodiment is shown in FIG. 18. It comprises a plurality (five in this example) plastic bodies 94 which are essentially shaped as cuboids and are configured respectively to build a form-fit or form-locking connection with one or two other plastic bodies 94. In the present embodiment, this form-fit connection is realized by respective dovetail joints 95, one of which is displayed in a magnified view within a contour 97. Each plastic body 94 on one side comprises a pin 99 and on the other or opposing side a tail 100. To establish the dovetail joint 95, pin 99 engages with tail 100.

This embodiment of the capacitive module 8 is produced by injecting plastic material into a mold 50 with a cavity 51 in which one or several separate electrodes 7 are housed and which is shaped as to allow the melted plastic material to flow into the cavity to embed partially the respective electrode 7 and to form a plastic body 94. The cavity 51 is preferably adapted to allow toe production of several plastic bodies 94, each one partially embedding one or more electrodes 7 (one in the embodiment illustrated in FIGs.18-19), during one operation of injection melted plastic material 60 into the mold 50. The plastic bodies 94 attached to each other build the support element 9. This configuration of the capacitive module 8 allows combining plastic bodies 94 in various numbers to obtain capacitive modules 8 with a varying number of electrodes 7.

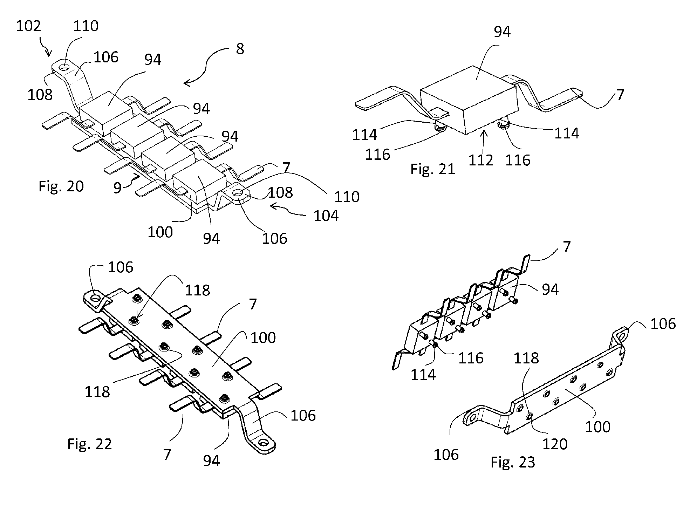

In FIG. 20, yet another preferred embodiment of a capacitive module 8 is shown which comprises several plastic bodies 94. Plastic bodies 94 are attached to a common rack 100. Hence, in contrast to the embodiment of FIGs. 18 and 19, plastic bodies 94 are preferably not mutually connected to each other but remain in position due to being mounted on rack 100. In other possible embodiments, additional connections between the plastic bodies 94 can also be provided to provide additional stability of the capacitive module 8.

On its sides 102, 104, rack 100 preferably comprises connection elements 106 designed as angled flaps or clips with a connection part 108 with a hole 110, respectively. Rack 100 in this way can be placed at box or user interface or electronic board and fixed, for instance, by screws which go through holes 110.

A single plastic body 94 of the capacitive module 8 according to FIG. 20 is displayed in FIG. 21. It comprises an essentially cuboid shape. On a bottom side 112, it comprises pegs 114 which at their ends respectively comprise a fixing element 116, which are preferably made of elastic material and allow a compression in radial direction. In their usual state, they comprise a diameter larger than pegs 114.

In FIG. 22, rack 100 is displayed in an assembled state with four plastic bodies 94. Pegs 114 have been received by holes 118 in rack 100 to establish a plug connection between respective plastic body 94 and common rack 100. As can be seen in FIG. 23 which shows an exploded view of plastic bodies 94 and rack 100, holes 118 are surrounded, respectively, by a resistance element 120. When pegs 114 are put through holes 118, fixing elements 116 are temporarily compressed and assume their original shape after the plug connection has been established, i.e., the respective plastic bodies assumes their position closest to rack 100. Fixing elements 116 then assume a diameter larger than holes 118 and the resistance elements, and essentially act as elastic engagement hooks.

Still another possible embodiment can be constructed/designed with separate plastic bodies 94 which on one side comprise at least one peg and on the other side comprise at least one hole which can be engaged in order to provide a form-fit connection between the respective elements. Preferably, two pegs and two holes are used. The invention comprises all possible embodiments in which plastic bodies 94 or bodies of non-conductive material, in which an electrode 7 is partially embedded, can be mechanically connected to each other to form a capacitive module 8.

## Claims

1. Household appliance (1) provided with a control panel (2) comprising:
- a user interface (3) comprising one or more capacitive touch input regions (4);
- an electronic board (5) comprising one or more electrically conductive tracks (6);
- one or more electrodes (7) having two ends (7a, 7b), one end (7a) being electrically connected to one of said one or more electrically conductive tracks (6) and the other end (7b) being positioned at or in proximity of one of said one or more capacitive touch input regions (4),
said household appliance (1) **being characterized by** comprising a capacitive module (8) comprising an insulating support element (9), made at least partially of electrically insulating material, in which said one or more electrodes (7) are fixed and partially embedded.

2. Household appliance (1) according to claim 1 comprising at least two electrodes (7) fixed and partially embedded in said insulating support element (9) in such a way to be reciprocally electrically insulated one another.

3. Household appliance (1) according to claim 1 or 2, wherein said insulating support element (9) comprises a single plastic body (10) obtained by injection molding and over-injected on all said one or more electrodes (7) in such a way to partially embed all of them and to allow said two ends (7a, 7b) of each electrode (7) to protrude externally from said plastic body (10).

4. Household appliance (1) according to claim 1 or 2, wherein said insulating support element (9) comprises a plurality of plastic bodies (94) obtained by injection molding and each one over-injected on at least one of said one or more electrodes (7) in such a way to partially embed it and to allow said two ends (7a, 7b) of said at least one of said one or more electrodes (7) to protrude externally from said plastic body (94).

5. Household appliance (1) according to claim 4, wherein said plurality of plastic bodies (94), each comprising at least one of said one or more electrodes (7), are connected one another after their injection molding so as to form said capacitive module (8).

6. Household appliance (1) according to claim 4 or 5, wherein said plurality of plastic bodies (94), each comprising at least one of said one or more electrodes (7), are fixed to a rack (100) supporting them.

7. Household appliance (1) according to one or more of the previous claims, wherein said control panel (2) comprises a front wall (12) having an external surface (13) facing the external of the appliance (1) and comprising said one or more capacitive touch input regions (4), said control panel (2) comprising an internal surface (14) provided in or in proximity of said front wall (12) and facing said electronic board (5), said capacitive module (8) being positioned between said electronic board (5) and said internal surface (14).

8. Household appliance (1) according to claim 7, wherein said control panel comprises a box (15) housing said electronic board (5) and having an external wall (16) facing said front wall (12) of said control panel (2), said external wall (16) comprising said internal surface (14) facing said electronic board (5)

9. Household appliance (1) according to one or more of the previous claims, wherein said end (7b) of said one or more electrodes (7) positioned at or in proximity of one of said one or more capacitive touch input regions (4) abuts against said internal surface (14) of said control panel (2), and is made of an elastic conductive material so as to elastically adapt its shape/position to the actual distance between the respective conductive track (6) and said internal surface (14) of said control panel (2).

10. Household appliance (1) according to one or more of the previous claims wherein said household appliance (1) is a laundry washing machine or a laundry drier or a washer-drier.

11. Method for manufacturing a capacitive module (8) for a household appliance (1) control panel (2), comprising the following steps:
a) providing a mold (50) adapted to house one or more electrodes (7), said mold (50) being arranged in such a way that by injecting a melted insulating plastic material in said mold (50) after housing said one or more electrodes (7) therein, said one or more electrodes (7) are partially embedded in a plastic body (10, 94) formed by said plastic material and protrude with two ends (7a, 7b) from said plastic body (10, 94);
b) housing one or more electrodes (7) in said mold (50);
c) injecting a melted insulating plastic material in said mold (50), so as to obtain a capacitive module (8) comprising said one or more electrodes (7) and a plastic body (10, 94) partially embedding said one or more electrodes (7);
d) extracting said capacitive module (8) from said mold (50).

12. Method according to claim 11, wherein said mold (50) is adapted to house a plurality of electrodes (7), one spaced apart from the others, said step b) comprising housing a plurality of electrodes (7), one spaced apart from the others, in said mold (50).

13. Method according to claim 11, wherein said mold is adapted to house a single metallic body (40) comprising a plurality of electrodes (7), said step b) comprising housing said single metallic body (40) in said mold (50), wherein said method comprises, after said step c), the following step:
c1) reciprocally separating said electrodes (7) of said metallic body (40) so as to electrically insulate them one another, while keeping them partially embedded in said plastic body (10).

14. Method according to claim 13, wherein said step c1) is performed before performing said phase d).

15. Method, according to claim 11 or 12, comprising producing a capacitive module (8) with a plurality of plastic bodies (94), each one embedding one or more electrodes (7), said method further comprising the step of connecting said plurality of plastic bodies (94) one to the other via respective plastic bodies (94).
